# FASCICULE DE BREVET EUROPEEN

(11) **EP 2 320 402 B1**
(45) Date de publication et mention de la délivrance du brevet: **30.08.2017**
(21) Numéro de dépôt: 10189835.1
(22) Date de dépôt: 03.11.2010
(51) Int. Cl.: G08C 17/02, H02J 7/35, H01L 31/05

(54) **Dispositif de commande et/ou d'obtention d'information à distance de l'état de produits de type domotique, comprenant un panneau photovoltaïque annulaire**
Vorrichtung zur Fernsteuerung und/oder Informationsabfrage von Haushaltsgeräten mit einem ringförmigen Photovoltaikpanel
Remote control and/or information collecting device for home automation appliances comprising a ring-shaped photovoltaic panel.

(30) Priorité: 04.11.2009 FR 0957780
(43) Date de publication de la demande: 11.05.2011
(73) Titulaire: Somfy SAS, 74300 Cluses (FR)
(72) Inventeur: Geriniere, Pierre, 74300 Cluses (FR); Rousseau, Fabien, 74300 Magland (FR); Guillerez, Stephane, 73610 Lepin Le Lac (FR); De Bettignies, Rémi, 38110 Saint Clair de la Tour (FR)
(74) Mandataire: Novaimo

(56) Documents cités:
- EP-A1- 0 973 139
- EP-A2- 1 484 728
- FR-A1- 2 606 912
- US-A1- 2006 157 105

## Description

L'invention concerne le domaine de la commande à distance de produits domotiques d'un bâtiment. En particulier, l'invention concerne un dispositif de contrôle de produits de type domotique, comprenant un émetteur et/ou un récepteur alimenté(s) au moyen d'un élément photovoltaïque.

De nombreux dispositifs liés à la commande à distance de produits de type domotique sont réalisés sous forme de « point de commande mural » ou « afficheur mural » ou « capteur mural » dans une dimension réduite le plus souvent normalisée (par exemple 5cm x 5cm selon une norme DIN).

Le dispositif est entouré par un cadre apte à s'harmoniser avec la décoration intérieure. L'épaisseur du dispositif est voisine de celle du cadre, par exemple 8 mm. Fixation directe sur un mur ou sur une cloison verticale, par autocollant ou par vis, sans raccordement filaire : le dispositif est autonome et communicant, par exemple au moyen d'un émetteur radiofréquences (RF).

Dans de nombreux dispositifs de l'art antérieur, l'alimentation est réalisée par une pile bouton. Il est cependant connu d'alimenter le dispositif par un élément photovoltaïque, comme dans la demande de brevet JP8009469.

Le logement de l'élément photovoltaïque dans le cadre pose des problèmes de connectique ou des problèmes d'encombrement, et se heurte à la disparité de cadres disponibles.

Le logement de l'élément photovoltaïque dans le dispositif lui-même conduit à réduire le plus souvent les dimensions de cet élément, du fait de composants fonctionnels du dispositif : par exemple un ensemble de touches de commande, des moyens d'affichage, une antenne radio. Il en résulte alors une diminution des possibilités de conversion photoélectrique et donc une plus faible énergie disponible dans le dispositif, conduisant par exemple à une réduction de performance.

Par exemple, cette réduction se traduit par une diminution de la portée radio ou se traduit par l'impossibilité d'adjoindre un récepteur RF à l'émetteur, ou encore se traduit par une augmentation du temps de chargement d'un élément de stockage (le courant de charge étant plus faible du fait de la réduction de la surface de l'élément photovoltaïque) rendant le dispositif inopérant dans certaines conditions, ce qui est inacceptable dans le cadre du contrôle de produits domotiques assurant une fonction de confort et/ou de sécurité dans un bâtiment.

De plus, des raisons fonctionnelles et/ou esthétiques incitent souvent à disposer ces composants fonctionnels au centre du dispositif, créant ainsi des problématiques d'agencement des éléments photovoltaïques dans le dispositif.

On connaît du document FR 2 606 912 un émetteur comprenant un circuit électronique et un actionneur pour actionner un interrupteur et comprenant une cellule photovoltaïque.

On connaît aussi du document US 2006/157105 une conception de cellule photovoltaïque permettant d'optimiser le transfert d'énergie, la surface sensible étant optimisée relativement à son encombrement.

Le but de l'invention est de fournir un dispositif de contrôle remédiant aux inconvénients ci-dessus et améliorant les dispositifs de contrôle connus de l'art antérieur. En particulier, l'invention permet de réaliser un dispositif simple, compact et présentant une grande autonomie.

Par « dispositif de contrôle de produits domotiques », on entend un dispositif de commande de ce ou ces produits, d'information vis-à-vis de l'état de ces produits ou de programmation de ces produits.

Selon l'invention, le dispositif est défini par la revendication 1.

Différents modes de réalisation du dispositif sont définis par les revendications dépendantes.

L'invention sera mieux comprise à la lecture de la description qui va suivre, donnée uniquement à titre d'exemple et faite en se référant aux dessins annexés sur lesquels :
La figure 1 représente sous forme de schéma-blocs un transmetteur radiofréquences utilisant l'invention.
La figure 2 représente, en vue de dessus, une face avant du transmetteur dans un premier mode de réalisation.
La figure 3 représente, en vue de dessus, une première variante, appliquée au premier mode de réalisation.
La figure 4 représente, en vue de dessus, une face avant du transmetteur dans un deuxième mode de réalisation.
La figure 5 représente, en vue de dessus, une deuxième variante, applicable aux deux modes de réalisation.
La figure 6 représente partiellement, en vue de dessus, une face avant du transmetteur dans un troisième mode de réalisation.
La figure 7 représente, en coupe, le transmetteur radiofréquences installé dans un cadre mural.

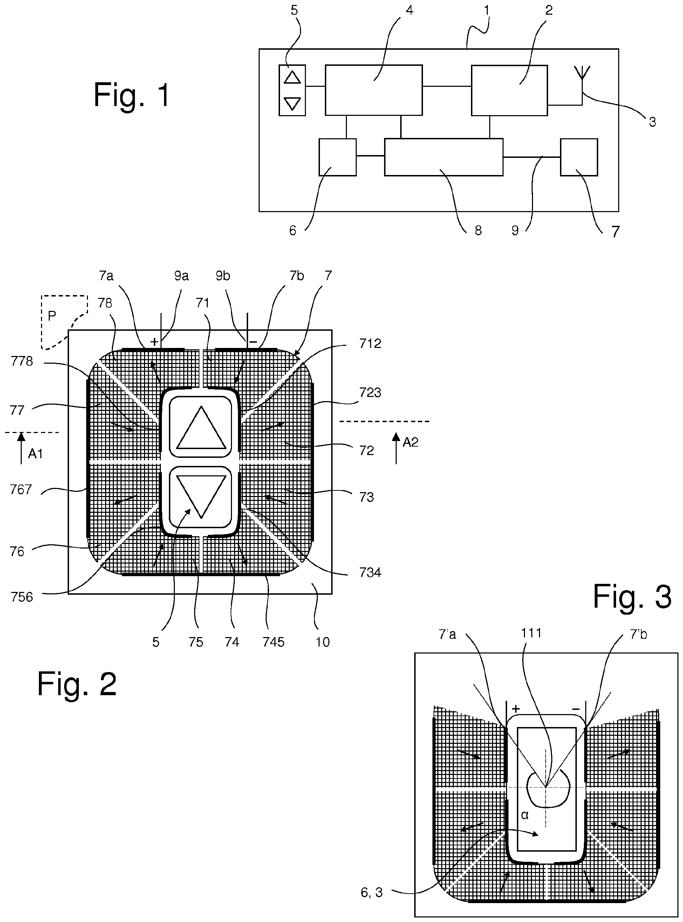

La figure 1 représente sous forme de schéma-blocs un dispositif de contrôle de produits domotiques, tel qu'un transmetteur radiofréquences 1, utilisant l'invention. Ce transmetteur domotique comprend une unité radiofréquences 2 (de type émetteur) raccordée à une antenne 3, pour communiquer par radiofréquences avec un récepteur ou plusieurs récepteurs, non représenté(s). Le transmetteur comprend une unité de commande 4, par exemple un microcontrôleur raccordé à l'émetteur radiofréquences. Les données transmises par l'unité de commande sont transformées en signaux radioélectriques par l'unité radiofréquences pour être appliqués à l'antenne. Un clavier de commande 5, comprenant des interrupteurs, est raccordé à l'unité de commande, par exemple sur une entrée logique, pour appliquer des ordres transmis manuellement par un utilisateur en agissant sur les interrupteurs. Un capteur 6, par exemple un capteur de présence ou un capteur de température ou d'humidité, est également raccordé à l'unité de commande, par exemple sur une entrée analogique. Un tel dispositif de contrôle permet de commander à distance l'état de produits de type domotique et/ou d'informer à distance sur l'état de produits de type domotique. Les produits domotiques sont des équipements assurant une fonction de confort et/ou de sécurité dans un bâtiment, comme des dispositifs d'éclairage ou de chauffage-climatisation, des dispositifs de volets roulants, de stores, des dispositifs d'écrans, dispositifs de manoeuvre de porte ou de portail, des dispositifs d'alarmes ou des capteurs utilisés dans le fonctionnement de ces dispositifs.

L'unité de commande et l'émetteur radiofréquences sont alimentés par un circuit d'alimentation 8 raccordé à un élément photovoltaïque 7 par un moyen de connexion électrique 9. Le circuit d'alimentation comprend un condensateur de stockage (ou un accumulateur) et par exemple un circuit adaptateur de tension permettant la charge optimale du condensateur de stockage en fonction de l'éclairement de l'élément photovoltaïque.

Le transmetteur radiofréquences peut également ou alternativement comprendre un récepteur, et/ou le clavier être remplacé par un moyen d'affichage afin de permettre l'affichage d'une information. Il peut également être utilisé un dispositif d'interface homme machine, comprenant un moyen de saisie et un moyen d'affichage, et un circuit émetteur-récepteur.

La figure 2 représente, en vue de dessus, une face avant du transmetteur dans un premier mode de réalisation.

Le transmetteur est rectangulaire, préférentiellement sous forme d'un carré de 5 cm x 5 cm, ce qui correspond à un standard électrique européen. Il comprend un couvercle 10 en matière plastique transparente ou translucide recouvrant et protégeant un élément photovoltaïque 7 dont la surface sensible est orientée vers l'extérieur du transmetteur, et directement placée au contact du couvercle.

Le couvercle peut comprendre un réseau de micro-lentilles aptes à focaliser les rayons lumineux sur les parties actives de la surface sensible. Le couvercle a subi un traitement anti-rayures et/ou anti-salissures sur sa face extérieure, plane. La présence de micro-lentilles ou autre motif périodique sur la face inférieure du couvercle permet de masquer partiellement des traces de doigt.

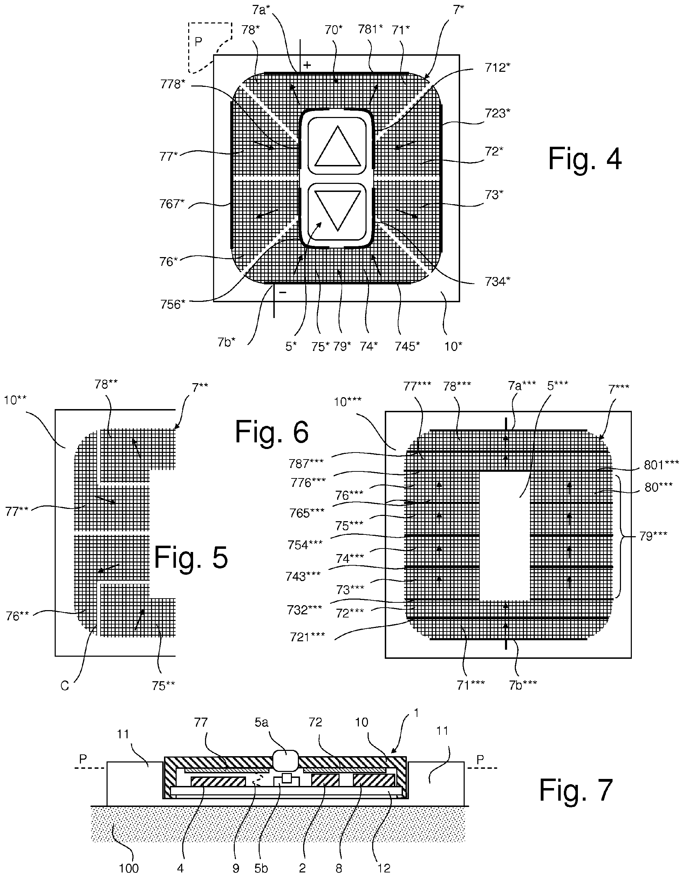

Le couvercle supporte un composant fonctionnel tel que le clavier de commande 5 dans sa partie centrale. Ce clavier comprend deux touches de commande, traversant le couvercle et activant des contacts placés sous le couvercle, comme détaillé plus bas en relation avec la figure 6.

L'élément photovoltaïque comprend un pôle positif 7a et un pôle négatif 7b raccordés au circuit d'alimentation par une première connexion 9a et une deuxième connexion 9b du moyen de connexion électrique. L'élément photovoltaïque a une forme d'anneau plat, entourant le composant fonctionnel. En particulier, l'élément photovoltaïque est un seul ensemble de cellules photovoltaïques, déployé de manière non linéaire autour du composant fonctionnel.

L'élément photovoltaïque entoure le composant fonctionnel. Autrement dit, la surface sur laquelle s'appuie l'élément photovoltaïque est traversée par au moins une partie du composant fonctionnel.

L'élément photovoltaïque peut n'entourer que partiellement le composant fonctionnel, c'est-à-dire que l'angle a sous lequel est vu l'élément photovoltaïque depuis l'intersection d'un axe central 111 de l'élément fonctionnel avec la surface sur laquelle se trouve ou s'appuie l'élément fonctionnel est supérieur à 270°, voire supérieur à 300°, voire supérieure à 330°.

Cet anneau est sectorisé : l'élément photovoltaïque comprend une pluralité d'éléments adjacents mis en série et présentant deux à deux des polarités alternées dans le sens radial. Les polarités respectives des éléments sont représentées par des flèches.

Ainsi, le pôle négatif 7b est raccordé à un premier élément adjacent 71 de polarité centripète, voisin d'un deuxième élément adjacent 72 de polarité centrifuge. Le deuxième élément adjacent est lui-même voisin d'un troisième élément adjacent 73 de polarité centripète. Le troisième élément adjacent est lui-même voisin d'un quatrième élément adjacent 74 de polarité centrifuge. Le quatrième élément adjacent est lui-même voisin d'un cinquième élément adjacent 75 de polarité centripète. Le cinquième élément adjacent est lui-même voisin d'un sixième élément adjacent 76 de polarité centrifuge. Le sixième élément adjacent est lui-même voisin d'un septième élément adjacent 77 de polarité centripète. Le septième élément adjacent est lui-même voisin d'un huitième élément adjacent 78 de polarité centrifuge. Ce huitième élément adjacent est voisin du premier élément adjacent. Un anneau plat complet est ainsi réalisé autour du composant fonctionnel. Les éléments adjacents occupent autant de surface que possible sur la partie interne de couvercle laissée libre par le composant fonctionnel, parallèlement au plan principal du couvercle. Les aires des éléments adjacents sont égales entre elles de manière à équilibrer le fonctionnement de tous les éléments adjacents pour un éclairement commun donné.

Un élément adjacent comprend une électrode interne et une électrode externe respectivement disposées sur un bord intérieur et sur un bord périphérique de l'anneau.

Deux électrodes internes peuvent être connectées pour deux éléments adjacents voisins, soit formant une électrode interne (relativement à l'élément photovoltaïque de forme annulaire) unique, soit par liaison galvanique de deux électrodes internes (relativement à l'élément photovoltaïque de forme annulaire) séparées.

Ainsi, une première électrode interne 712 est commune aux éléments adjacents 71-72, une deuxième électrode interne 734 est commune aux éléments adjacents 73-74, une troisième électrode interne 756 est commune aux éléments adjacents 75-76 et une quatrième électrode interne 778 est commune aux éléments adjacents 77-78.

De même, deux électrodes externes peuvent être connectées pour deux éléments adjacents voisins, soit formant une électrode externe (relativement à l'élément photovoltaïque de forme annulaire) unique, soit par liaison galvanique de deux électrodes externes (relativement à l'élément photovoltaïque de forme annulaire) séparées.

Ainsi, une première électrode externe 723 est commune aux éléments adjacents 72-73, une deuxième électrode externe 745 est commune aux éléments adjacents 74-75 et une troisième électrode externe 767 est commune aux éléments adjacents 76-77.

De manière générale, un premier élément adjacent, compris entre un deuxième élément adjacent et un troisième élément adjacent, est connecté au premier élément adjacent par liaison de chaque électrode externe et est connecté au troisième élément adjacent par liaison de chaque électrode interne.

La situation est différente pour deux éléments adjacents particuliers 71 et 78 connectés chacun à un seul élément adjacent, respectivement 72 et 77, les électrodes non connectées de ces éléments adjacents particuliers constituant les pôles 7b et 7a de l'élément photovoltaïque.

Du fait de cette disposition, tous les éléments adjacents sont mis en série, les tensions aux bornes des éléments s'ajoutant les unes aux autres entre les deux pôles.

La figure 3 représente, en vue de dessus, une première variante, appliquée au premier mode de réalisation.

Dans cette première variante, un élément photovoltaïque 7' de pôles 7'a, 7'b, comprend un anneau partiellement ouvert, par exemple du fait de contraintes particulières sur le couvercle, mais il entoure autant que possible le composant fonctionnel.

Les éléments particuliers et les pôles, qui étaient voisins dans la figure 2, sont distants dans la première variante. Les pôles sont ici situés sur des électrodes internes. Le composant fonctionnel entouré par l'anneau ouvert est par exemple le capteur 6 ou l'antenne 3. Alternativement, le composant fonctionnel est un petit écran d'affichage.

La figure 4 représente, en vue de dessus, une face avant du transmetteur dans un deuxième mode de réalisation.

Le deuxième mode de réalisation diffère du premier mode de réalisation par un choix différent de l'emplacement des pôles et du sens des polarisations et par le fait que les éléments adjacents particuliers 70* et 79* présentent une aire double de celle des autres éléments adjacents.

Un élément photovoltaïque 7* selon ce deuxième mode comprend un pôle positif 7a* et un pôle négatif 7b* situés sur des électrodes externes opposées, de part et d'autre de l'élément fonctionnel.

Sur la figure 4, on a repris les références de la figure 2 en ajoutant un astérisque pour des références analogues. Cependant, les éléments adjacents 71* à 74* ont des polarités respectivement opposées par rapport aux éléments adjacents 71 à 74 de la figure 2. De ce fait, les éléments adjacents 71* et 78* ont la même polarité, et de même les éléments adjacents 74* et 75* ont la même polarité.

Ces éléments peuvent donc être réunis sous une référence unique, la référence 70* désignant l'ensemble des éléments adjacents 71* et 78*, et la référence 79* désignant l'ensemble des éléments adjacents 74* et 75*.

Ces deux ensembles constituent donc des éléments adjacents particuliers, raccordés chacun à un pôle et dont l'aire est double de celle des éléments adjacents. Le pôle négatif est raccordé à une électrode externe 745* disposée à la périphérie de l'anneau sur l'élément adjacent particulier 79* et le pôle positif est raccordé à une électrode externe 781* disposée à la périphérie de l'anneau, sur l'élément adjacent particulier 70*. Avantageusement, les deux électrodes internes 712* et 778* peuvent ne former qu'une seule électrode non connectée à d'autres éléments adjacents, et de même les deux électrodes 734* et 756* peuvent ne former qu'une seule électrode, non connectée à d'autres éléments adjacents.

Ce mode de réalisation est donc particulièrement simple, et l'élément photovoltaïque contient donc deux voies en parallèles, chaque voie comprenant la mise en série de quatre éléments, dont les éléments extrêmes se combinent pour former des éléments adjacents particuliers, les électrodes non connectées des éléments adjacents particuliers constituant des pôles d'alimentation du dispositif.

La figure 5 représente, en vue de dessus, une deuxième variante, applicable aux deux modes de réalisation. Il est important que les aires des éléments adjacents soient égales, mais la forme des éléments adjacents peut être quelconque, pourvu que la résistance électrique des éléments, vue entre électrodes, soit égale. Il peut être avantageux d'imbriquer les éléments adjacents de manière à équilibrer les comportements photovoltaïques. Une imbrication en chevrons permet de répartir sur plusieurs éléments adjacents une éventuelle inhomogénéité dans l'éclairement.

La figure 5 donne un exemple d'imbrication, en reprenant partiellement la figure 2 et en affectant un astérisque double à des références équivalentes.

Les polarisations sont toujours radiales et alternées. Par « radial(e) », on entend une direction traversant un bord interne et un bord périphérique de l'anneau.

La figure 6 représente partiellement, en vue de dessus, une face avant du transmetteur dans un troisième mode de réalisation. Le troisième mode de réalisation diffère des deux premiers modes par le fait que des éléments adjacents présentent un même sens des polarités, un pôle d'un premier élément adjacent étant voisin d'un pôle opposé d'un deuxième élément adjacent.

Les éléments adjacents ne sont séparés que par des électrodes permettant de raccorder directement les pôles voisins des éléments adjacents.

Comme dans le deuxième mode de réalisation, l'élément photovoltaïque du troisième mode de réalisation contient deux voies en parallèles, chaque voie comprenant la mise en série de quatre éléments adjacents, les voies étant situées de part et d'autre d'un composant fonctionnel 5***. Pour simplifier, on distingue par élément adjacent simple les éléments adjacents situés sur chaque voie parallèle. Ces éléments adjacents simples portent les références 73*** à 76*** pour une première voie et portent collectivement la référence 79*** pour une deuxième voie.

La surface des différents éléments adjacents simples est égale. Les éléments extrêmes de chaque voie sont reliés à des éléments adjacents intermédiaires dont la surface est double de celle des éléments adjacents simples.

Ainsi, l'élément adjacent simple 73*** est relié à un premier élément adjacent intermédiaire 72*** tandis que l'élément adjacent simple 76*** est relié à l'élément adjacent intermédiaire 77***. De même, les éléments adjacents simples 79*** situés aux extrêmes de la deuxième voie sont raccordés au premier élément adjacent intermédiaire 72*** et au deuxième élément adjacent intermédiaire 77***.

Le premier élément adjacent intermédiaire 72*** est lui-même raccordé à un premier élément adjacent particulier 71***, également de surface double de celle des éléments adjacents simples, et à une électrode non connectée 7b*** constituant un premier pôle d'alimentation du dispositif.

Le deuxième élément adjacent intermédiaire 77*** est lui-même raccordé à un deuxième élément adjacent particulier 78***, également de surface double de celle des éléments adjacents simples, et à une électrode non connectée 7a*** constituant un deuxième pôle d'alimentation du dispositif.

La figure 7 représente, selon une coupe A1A2, le transmetteur radiofréquences 1 installé dans un cadre mural 11 fixé sur un mur 100. Le plan du mur est parallèle au plan principal P du couvercle 10.

Le couvercle présente des bords latéraux supportant un circuit imprimé 12 également parallèle au plan principal du couvercle. Le couvercle est en matériau électriquement isolant.

Le clavier de commande 5 comprend une touche 5a traversant le clavier et activant un interrupteur 5b quand elle est enfoncée. L'interrupteur est disposé sur un circuit imprimé 12, sur lequel sont également disposés l'unité de commande 4, l'unité radiofréquences 2 et le circuit d'alimentation 8. Les éléments adjacents 77 et 72 sont disposés sur la surface interne du couvercle, parallèlement au plan principal P. Le moyen de connexion 9 (apparaissant en trait pointillé) raccorde l'ensemble de l'élément photovoltaïque au circuit d'alimentation via le circuit imprimé.

En variante de réalisation, l'anneau formé par l'élément photovoltaïque n'est pas symétrique, mais l'invention est d'autant plus simple à mettre en oeuvre qu'on utilise une structure symétrique. Les meilleures performances sont obtenues pour un anneau complet.

Le matériau photovoltaïque est préférentiellement de type organique. Les dépôts du matériau photovoltaïque et des électrodes conductrices sont préférentiellement réalisés par une technique de jet d'encre.

Par « électrode non connectée », on entend « non connectée à un élément adjacent ».

Par « disposé au moins sensiblement selon un plan », on entend « disposé selon un plan » ou « disposé sensiblement selon un plan ».

Par « au moins sensiblement parallèle », on entend « parallèle » ou « sensiblement parallèle ».

L'invention s'applique également à un dispositif de type nomade.

En maximisant l'aire de l'élément photovoltaïque, l'invention permet notamment l'utilisation du dispositif de contrôle à distance sous de faibles éclairements. Un dépôt photovoltaïque étant conducteur, il présente un écran pour les ondes électromagnétiques émises par l'émetteur radiofréquences 2. Un dernier avantage de l'invention est de maintenir une zone non-conductrice relativement centrale sur toute la surface occupée par le composant fonctionnel et d'éviter une dégradation des performances de cet émetteur du fait de l'élément photovoltaïque.

Dans le présent document, par « imbrication de deux formes géométriques ou deux éléments », on comprend que les deux formes géométriques ou éléments sont complémentaires ou sensiblement complémentaires. Ces formes sont de préférences limitées à des formes filaires sur une surface, en particulier à des formes en deux dimensions sur le plan principal du couvercle ou à des projections de formes sur le plan principal du couvercle. En particulier, pour qu'il y ait imbrication de formes géométriques de deux parties, il n'est pas nécessaire que l'ensemble d'un bord intérieur d'une partie soit complémentaire ou sensiblement complémentaire de l'ensemble d'un bord extérieur de l'autre partie. Il faut et il suffit qu'une partie présente une concavité en vis-à-vis d'une convexité de l'autre partie et que ces concavité et convexité soient complémentaires ou sensiblement complémentaires. Ainsi, deux segments rectilignes ne peuvent pas être considérés comme deux formes géométriques imbriquées.

## Revendications

1. Dispositif (1) de contrôle de produits de type domotique, comprenant un composant fonctionnel (5) de contrôle d'un ou plusieurs produits domotiques, un émetteur (2) et/ou un récepteur d'informations de contrôle et un élément photovoltaïque (7) alimentant l'émetteur et/ou récepteur, **caractérisé en ce que** l'élément photovoltaïque, notamment en forme d'anneau, entoure, au moins partiellement, une partie du composant fonctionnel et est traversé par au moins une partie de ce dernier.

2. Dispositif selon la revendication 1, **caractérisé en ce qu'**il est de type mural, **en ce que** l'élément photovoltaïque est disposé selon un plan (P) dit « principal » et **en ce qu'**il comprend des moyens de fixation à un mur tels qu'une fois le dispositif fixé au mur, le plan principal est au moins sensiblement parallèle au plan du mur.

3. Dispositif selon la revendication 1 ou 2, **caractérisé en ce que** l'élément photovoltaïque comprend des éléments adjacents (71-78 ; 71*-78*) et de polarités alternées dans le sens radial, chaque élément adjacent présentant une électrode interne (712, 734, 756, 778 ; 712*, 734*, 756*, 778*) et une électrode externe (723, 745, 767 ; 723*, 745*, 767*) respectivement disposées sur un bord intérieur et sur un bord périphérique de l'élément photovoltaïque.

4. Dispositif selon la revendication 3, **caractérisé en ce qu'**un premier élément adjacent (72 ; 72*), compris entre un deuxième élément adjacent (73 ; 73*) et un troisième élément adjacent (71 ; 71*), est connecté au deuxième élément adjacent par liaison de l'électrode externe (723 ; 723*) du premier élément adjacent à l'électrode externe (723 ; 723*) du deuxième élément adjacent et est connecté au troisième élément adjacent par liaison de l'électrode interne (712 ; 712*) du premier élément adjacent à l'électrode interne (712 ; 712*) du deuxième élément adjacent.

5. Dispositif selon l'une des revendications 1 à 2, **caractérisé en ce que** l'élément photovoltaïque comprend des éléments adjacents (71***-78***) et **en ce qu'**un premier élément adjacent (74***), compris entre un deuxième élément adjacent (75***) et un troisième élément adjacent (73***), est connecté au deuxième élément adjacent par une électrode commune (754***) disposée entre les premier et deuxième éléments adjacents et est connecté au troisième élément adjacent par une électrode commune (743***) disposée entre les premier et troisième éléments adjacents.

6. Dispositif selon la revendication précédente, **caractérisé en ce qu'**un quatrième élément adjacent (77***), compris entre un cinquième élément adjacent (78***) et des sixième (76***) et septième (80***) éléments adjacents, est connecté au cinquième élément adjacent par une électrode commune (787***) disposée entre les quatrième et cinquième éléments adjacents et est connecté aux sixième (76***) et septième (80***) éléments adjacents respectivement par une électrode commune (776***) disposée entre les quatrième et sixième éléments adjacents et par une électrode commune (801***) disposée entre les quatrième et septième éléments adjacents.

7. Dispositif selon la revendication 5 ou 6, **caractérisé en ce que** les éléments adjacents sont au moins sensiblement polarisés selon une même direction.

8. Dispositif selon l'une des revendications 3 à 7, **caractérisé en ce que** deux éléments adjacents présentent une aire égale.

9. Dispositif selon l'une des revendications 3 à 8, **caractérisé en ce que** l'élément photovoltaïque comprend deux éléments adjacents particuliers (71, 78 ; 71*, 78* ; 71***, 78***), éventuellement non adjacents entre eux, connectés chacun à un seul élément adjacent, les électrodes (7a, 7b ; 7a*, 7b* ; 7a***, 7b***) non connectées de ces éléments adjacents particuliers constituant des pôles d'alimentation du dispositif.

10. Dispositif selon l'une des revendications 3 à 9, **caractérisé en ce que** l'élément photovoltaïque comprend deux éléments adjacents particuliers (71*, 78* ; 71***, 78***) dont l'aire est double de celle des autres ou d'autres éléments adjacents, les électrodes non connectées (7a*, 7b* ; 7a***, 7b***) de ces éléments adjacents particuliers constituant des pôles d'alimentation du dispositif.

11. Dispositif selon l'une des revendications 3 à 10, **caractérisé en ce que** des éléments adjacents (77**, 78**) sont imbriqués.

12. Dispositif selon l'une des revendications 3 à 11, **caractérisé en ce que** l'élément photovoltaïque a une forme en U et comprend deux éléments adjacents particuliers connectés chacun à un seul élément adjacent, ces éléments adjacents particuliers étant situés aux extrémités du U.

13. Dispositif selon l'une des revendications précédentes, **caractérisé en ce que** le composant fonctionnel comprend un clavier de commande et/ou un moyen d'affichage et/ou un moyen de mesure et/ou un moyen de communication.

14. Dispositif selon l'une des revendications précédentes, **caractérisé en ce que** l'élément photovoltaïque est de type organique, déposé sur un couvercle (10) transparent et électriquement isolant.

## Patentansprüche

1. Vorrichtung (1) zur Kontrolle von Produkten vom Typ Haushaltsgeräte, umfassend ein Funktionsbauteil (5) zur Kontrolle eines oder mehrerer Haushaltsgeräte, einen Sender (2) und/oder einen Empfänger von Kontrollinformationen und ein Photovoltaikelement (7), das den Sender und/oder Empfänger versorgt, **dadurch gekennzeichnet, dass** das Photovoltaikelement, insbesondere in Ringform, zumindest teilweise einen Teil des Funktionsbauteils umgibt und von mindestens einem Teil dieses letztgenannten durchquert wird.

2. Vorrichtung nach Anspruch 1, **dadurch gekennzeichnet, dass** sie vom Typ mit Wandmontage ist, dass das Photovoltaikelement gemäß einer so genannten "Hauptebene" (P) angeordnet ist, und dass sie Mittel zur Befestigung an einer Wand umfasst, so dass, wenn die Vorrichtung an der Wand befestigt ist, die Hauptebene zumindest im Wesentlichen parallel zur Ebene der Wand ist.

3. Vorrichtung nach Anspruch 1 oder 2, **dadurch gekennzeichnet, dass** das Photovoltaikelement anliegende Elemente (71-78; 71*-78*) mit alternierenden Polaritäten in Radialrichtung umfasst, wobei jedes anliegende Element eine interne Elektrode (712, 734, 756, 778; 712*, 734*, 756*, 778*) und eine externe Elektrode (723, 745, 767; 723*, 745*, 767*) aufweist, die auf einem Innenrand bzw. auf einem Umfangsrand des Photovoltaikelements angeordnet sind.

4. Vorrichtung nach Anspruch 3, **dadurch gekennzeichnet, dass** ein erstes anliegendes Element (72; 72*), das zwischen einem zweiten anliegenden Element (73; 73*) und einem dritten anliegenden Element (71; 71*) angeordnet ist, an das zweite anliegende Element durch Verbindung der externen Elektrode (723; 723*) des ersten anliegenden Elements mit der externen Elektrode (723; 723*) des zweiten anliegenden Elements angeschlossen ist, und an das dritte anliegende Element durch Verbindung der internen Elektrode (712; 712*) des ersten anliegenden Elements mit der internen Elektrode (712; 712*) des zweiten anliegenden Elements angeschlossen ist.

5. Vorrichtung nach einem der Ansprüche 1 bis 2, **dadurch gekennzeichnet, dass** das Photovoltaikelement anliegende Elemente (71***-78***) umfasst, und dass ein erstes anliegendes Element (74***), das zwischen einem zweiten anliegenden Element (75***) und einem dritten anliegenden Element (73***) angeordnet ist, an das zweite anliegende Element durch eine gemeinsame Elektrode (754***), die zwischen den ersten und zweiten anliegenden Elementen angeordnet ist, angeschlossen ist, und an das dritte anliegende Element durch eine gemeinsame Elektrode (743***), die zwischen den ersten und dritten anliegenden Elementen angeordnet ist, angeschlossen ist.

6. Vorrichtung nach dem vorhergehenden Anspruch, **dadurch gekennzeichnet, dass** ein viertes anliegendes Element (77***), das zwischen einem fünften anliegenden Element (78***) und sechsten (76***) und siebenten (80***) anliegenden Elementen angeordnet ist, an das fünfte anliegende Element durch eine gemeinsame Elektrode (787***), die zwischen den vierten und fünften anliegenden Elementen angeordnet ist, angeschlossen ist, und an das sechste (76***) bzw. siebente (80***) anliegende Element durch eine gemeinsame Elektrode (776***), die zwischen den vierten und sechsten anliegenden Elementen angeordnet ist, und durch eine gemeinsame Elektrode (801***), die zwischen den vierten und siebenten anliegenden Elementen angeordnet ist, angeschlossen ist.

7. Vorrichtung nach Anspruch 5 oder 6, **dadurch gekennzeichnet, dass** die anliegenden Elemente zumindest im Wesentlichen in eine selbe Richtung polarisiert sind.

8. Vorrichtung nach einem der Ansprüche 3 bis 7, **dadurch gekennzeichnet, dass** zwei anliegende Elemente einen gleichen Flächenbereich aufweisen.

9. Vorrichtung nach einem der Ansprüche 3 bis 8, **dadurch gekennzeichnet, dass** das Photovoltaikelement zwei besondere anliegende Elemente (71, 78; 71*, 78*, 71***, 78***), die eventuell nicht aneinander anliegen, die jeweils an ein einziges anliegendes Element angeschlossen sind, aufweist, wobei die nicht angeschlossenen Elektroden (7a, 7b; 7a*, 7b*; 7a***, 7b***) dieser besonderen anliegenden Elemente Pole zur Versorgung der Vorrichtung darstellen.

10. Vorrichtung nach einem der Ansprüche 3 bis 9, **dadurch gekennzeichnet, dass** das Photovoltaikelement zwei besondere anliegende Elemente (71*, 78*; 71***, 78***) umfasst, deren Flächenbereich das Doppelte von jenem der anderen oder von anderen anliegenden Elementen ist, wobei die nicht angeschlossenen Elektroden (7a*, 7b*; 7a***, 7b***) dieser besonderen anliegenden Elemente Pole zur Versorgung der Vorrichtung darstellen.

11. Vorrichtung nach einem der Ansprüche 3 bis 10, **dadurch gekennzeichnet, dass** anliegende Elemente (77**, 78**) verschachtelt sind.

12. Vorrichtung nach einem der Ansprüche 3 bis 11, **dadurch gekennzeichnet, dass** das Photovoltaikelement eine U-Form hat und zwei besondere anliegende Elemente umfasst, die jeweils an ein einziges anliegendes Element angeschlossen sind, wobei diese besonderen anliegenden Elemente an den Enden des U angeordnet sind.

13. Vorrichtung nach einem der vorhergehenden Ansprüche, **dadurch gekennzeichnet, dass** das Funktionsbauteil eine Steuertastatur und/oder ein Anzeigemittel und/oder ein Messhilfsmittel und/oder ein Kommunikationsmittel umfasst.

14. Vorrichtung nach einem der vorhergehenden Ansprüche, **dadurch gekennzeichnet, dass** das Photovoltaikelement organischen Typs ist und auf einen transparenten oder elektrisch isolierenden Deckel (10) aufgebracht ist.

## Claims

1. Device (1) for controlling home automation products, comprising a functional component (5) for controlling one or more home automation products, an emitter (2) and/or a receiver of control data and a photovoltaic element (7) that supplies the emitter and/or receiver with power, **characterized in that** the photovoltaic element, which is in particular ringshaped, at least partially encircles one portion of the functional component and is passed through by at least one portion of the latter.

2. Device according to Claim 1, **characterized in that** it is wall-mounted, **in that** the photovoltaic element is placed in what is called a "main" plane (P) and **in that** it comprises means for fastening to a wall such that once the device has been fastened to the wall, the main plane is at least substantially parallel to the plane of the wall.

3. Device according to Claim 1 or 2, **characterized in that** the photovoltaic element comprises elements (71-78; 71*-78*) that are adjacent and of polarities that alternate in the radial direction, each adjacent element having an internal electrode (712, 734, 756, 778; 712*, 734*, 756*, 778*) and an external electrode (723, 745, 767; 723*, 745*, 767*) placed on an interior edge and on a peripheral edge of the photovoltaic element, respectively.

4. Device according to Claim 3, **characterized in that** a first adjacent element (72; 72*), comprised between a second adjacent element (73; 73*) and a third adjacent element (71; 71*), is connected to the second adjacent element by connecting the external electrode (723; 723*) of the first adjacent element to the external electrode (723; 723*) of the second adjacent element and is connected to the third adjacent element by connecting the internal electrode (712; 712*) of the first adjacent element to the internal electrode (712; 712*) of the second adjacent element.

5. Device according to one of Claims 1 to 2, **characterized in that** the photovoltaic element comprises adjacent elements (71***-78***) and **in that** a first adjacent element (74***), comprised between a second adjacent element (75***) and a third adjacent element (73***), is connected to the second adjacent element by a common electrode (754***) placed between the first and second adjacent elements and is connected to the third adjacent element by a common electrode (743***) placed between the first and third adjacent elements.

6. Device according to the preceding claim, **characterized in that** a fourth adjacent element (77***), comprised between a fifth adjacent element (78***) and sixth (76***) and seventh (80***) adjacent elements, is connected to the fifth adjacent element by a common electrode (787***) placed between the fourth and fifth adjacent elements and is connected to the sixth (76***) and seventh (80***) adjacent elements respectively by a common electrode (776***) placed between the fourth and sixth adjacent elements and by a common electrode (801***) placed between the fourth and seventh adjacent elements.

7. Device according to Claim 5 or 6, **characterized in that** the adjacent elements are at least substantially polarised in the same direction.

8. Device according to one of Claims 3 to 7, **characterized in that** two adjacent elements have an equal area.

9. Device according to one of Claims 3 to 8, **characterized in that** the photovoltaic element comprises two particular adjacent elements (71, 78; 71*, 78*; 71***, 78***) that are possibly not adjacent to each other, each of which is connected to a single adjacent element, the electrodes (7a, 7b; 7a*, 7b*; 7a***, 7b***) not connected to these particular adjacent elements forming the power terminals of the device.

10. Device according to one of Claims 3 to 9, **characterized in that** the photovoltaic element comprises two particular adjacent elements (71*, 78*; 71***, 78***) the area of which is double that of the other or of other adjacent elements, the electrodes (7a*, 7b*; 7a***, 7b***) not connected to these particular adjacent elements forming the power terminals of the device.

11. Device according to one of Claims 3 to 10, **characterized in that** the adjacent elements (77**, 78**) are interspersed.

12. Device according to one of Claims 3 to 11, **characterized in that** the photovoltaic element has a U shape and comprises two particular adjacent elements that are each connected to a single adjacent element, these particular adjacent elements being located at the ends of the U.

13. Device according to one of the preceding claims, **characterized in that** the functional component comprises a control keyboard and/or a displaying means and/or a measuring means and/or a communicating means.

14. Device according to one of the preceding claims, **characterized in that** the photovoltaic element is organic, deposited on a transparent cover (10) and electrically insulating.
